# EUROPÄISCHE PATENTSCHRIFT

(11) **EP 1 252 710 B1**
(45) Veröffentlichungstag und Bekanntmachung des Hinweises auf die Patenterteilung: **09.07.2003**
(21) Anmeldenummer: 00991541.4
(22) Anmeldetag: 20.12.2000
(51) Int. Cl.: H03G 3/00

(54) **VERFAHREN UND SCHALTUNGSANORDNUNG ZUR REGELUNG DER AUSGANGSLEISTUNG EINES LEISTUNGSVERSTÄRKERS**
METHOD AND CIRCUIT ARRANGEMENT FOR CONTROLLING THE OUTPUT POWER OF A POWER AMPLIFIER
PROCEDE ET CIRCUIT POUR REGULER LA PUISSANCE DE SORTIE D'UN AMPLIFICATEUR DE PUISSANCE

(30) Priorität: 02.02.2000 DE 10004434
(43) Veröffentlichungstag der Anmeldung: 30.10.2002
(73) Patentinhaber: SIEMENS AKTIENGESELLSCHAFT, 80333 München (DE)
(72) Erfinder: NAGEL, Jörg, 47800 Krefeld (DE); HERZBERG, Ralf, 47918 Tönnisvorst (DE)
(86) Internationale Anmeldenummer: DE0004570
(87) Internationale Veröffentlichungsnummer: WO01058013

(56) Entgegenhaltungen:
- US-A- 5 278 994
- US-A- 6 057 732

## Beschreibung

Die vorliegende Erfindung betrifft ein Verfahren zur Regelung der Ausgangsleistung eines Leistungsverstärkers, insbesondere eine Hochfrequenz-Leistungsverstärkers, nach dem Oberbegriff des Anspruches 1 sowie eine entsprechende Schaltungsanordnung nach dem Oberbegriff des Anspruches 6.

Von Hochfrequenz-Leistungsverstärkern ("Power Amplifier"), wie sie beispielsweise in Mobilfunkgeräten eingesetzt werden, wird gefordert, daß sie in der Lage sind, eine bestimmte einstellbare Ausgangsleistung abzugeben, welche gegenüber äußeren Störeinflüssen, wie beispielsweise Versorgungsspannungsoder Temperaturschwankungen, möglichst unempfindlich ist.

Aus diesem Grund wird eine Regelschleife oder ein Regelkreis vorgesehen, der eine von der Ausgangsleistung des Leistungsverstärkers abhängige Meßgröße erfaßt, deren augenblicklichen Wert (d.h. den Istwert) mit einem vorgegebenen Sollwert vergleicht und abhängig von dem Vergleichsergebnis eine Stellgröße erzeugt, welche dem Leistungsverstärker über einen Steuereingang zugeführt wird, um dessen Ausgangsleistung entsprechend einzustellen bzw. zu stabilisieren. Bei Hochfrequenz-Leistungsyerstärkern wird als die von der Ausgangsleistung des Leistungsverstärkers abhängige Meßgröße üblicherweise eine durch Gleichrichtung der Hochfrequenz gewonnene analoge Spannung verwendet.

Schaltungsanordnungen dieser Art sind bekannt, z.B. aus JP-A-11-346133 oder US-A-5 278 994.

Um die Kosten und den Platzbedarf gering zu halten, wird der Verstärker üblicherweise möglichst klein dimensioniert, so daß hinsichtlich der Ausgangsleistung des Leistungsverstärkers keine Reserve zur Verfügung steht. Die höchste benötigte Ausgangsleistung des Leistungsverstärkers wird gerade noch erreicht.

Die zuvor beschriebene Leistungsregelung funktioniert bei einem derartigen Leistungsverstärker jedoch einwandfrei nur für kleine bis mittlere Ausgangsleistungen des Leistungsverstärkers. Bei höheren Ausgangsleistungen des Leistungsverstärkers kann ein sogenannter "Rollover" eintreten, da über die von dem Regler erzeugte Stellgröße möglicherweise eine Ausgangsleistung angefordert wird, welche über der von dem Leistungsverstärker tatsächlich lieferbaren Ausgangsleistung liegt. Aufgrund des Kompressionsverhaltens des Leistungsverstärkers kehrt sich dann der Zusammenhang zwischen der Stellgröße und dem Istwert der zu der Ausgangsleistung proportionalen Meßgröße um (d.h. eine weitere Erhöhung der Stellgröße führt zu einer verringerten Ausgangsleistung des Leistungsverstärkers). Dies hat zur Folge, daß der Regler die Stellgröße dauernd erhöht, bis der Regelkreis seinen Anschlag (beispielsweise den Aussteuerbereich des Reglers) erreicht.

Der zuvor beschriebene "Rollover"-Betriebszustand besitzt jedoch gravierende Nachteile, da der Leistungsverstärker einen hinsichtlich Stromaufnahme und Linearität ungünstigen Arbeitspunkt einnimmt und bei Systemen mit gepulster Ausgangsleistung (beispielsweise in GSM-Mobilfunkgeräten) ein undefiniertes dynamisches Verhalten hervorgerufen wird, welches zu damit verbundenen Schaltspektrums- und Timingproblemen führt.

Um den zuvor erwähnten "Rollover" des Leistungsverstärkers zu verhindern, könnte vollständig auf eine Regelung verzichtet werden, womit jedoch nicht die eingangs beschriebenen Forderungen nach Stabilisierung der Ausgangsleistung des Leistungsverstärkers gegenüber Störeinflüssen eingehalten werden können.

Eine weitere Alternative wäre eine großzügige Dimensionierung des Leistungsverstärkers, so daß hinsichtlich der Ausgangsleistung des Leistungsverstärkers eine ausreichende Reserve zur Verfügung steht. Diese Vorgehensweise hätte jedoch eine Erhöhung der Kosten und des Platzbedarfs zur Folge.

Darüber hinaus könnte zur Vermeidung eines "Rollovers" anstelle der Ausgangsleistung der Ausgangsstrom des Leistungsverstärkers geregelt werden. Diese Vorgehensweise hätte jedoch wieder eine schlechte Stabilisierung der Ausgangsleistung in Bezug auf Störeinflüsse, wie beispielsweise Frequenz- oder Temperaturschwankungen oder Fehlanpassung, zur Folge.

Der vorliegenden Erfindung liegt daher die Aufgabe zugrunde, ein Verfahren sowie eine Schaltungsanordnung zur Regelung der Ausgangsleistung eines Leistungsverstärkers vorzuschlagen, womit während der Regelung der Ausgangsleistung ein "Rollover" zuverlässig vermieden werden kann.

Diese Aufgabe wird durch ein Verfahren mit den Merkmalen des Anspruches 1 bzw. eine Schaltungsanordnung mit den Merkmalen des Anspruches 6 gelöst. Die Unteransprüche definieren jeweils bevorzugte Ausführungsformen der vorliegenden Erfindung.

Erfindungsgemäß wird die Regelung der Ausgangsleistung des Leistungsverstärkers mit einer von der jeweils erzeugten Stellgröße abhängigen Charakteristik durchgeführt, wobei die Verstärkung des zur Erzeugung der Stellgröße eingesetzten Reglers in Abhängigkeit von dem augenblicklichen Wert der Stellgröße eingestellt wird.

Bei Stellgrößen, wie sie bei niedrigen bis mittleren Ausgangsleistungen des Leistungsverstärkers auftreten, arbeitet der Regler mit einer hohen Verstärkung, während bei höheren Stellgrößen, insbesondere bei Stellgrößen im Bereich der Maximalleistung des Leistungsverstärkers, die Verstärkung des Regelkreises verringert wird, so daß die Stellgröße anschließend nur noch mit geringem Durchgriff dem jeweiligen Sollwert folgt. Da die Stellgröße auf diese Art und Weise frühzeitig begrenzt wird, kann ein "Rollover" zuverlässig vermieden werden.

Die Verringerung der Verstärkung des Regelkreises kann beispielsweise dadurch erzielt werden, daß ein über einen Rückkopplungszweig rückgekoppelter Regler verwendet wird, wobei der Rückkopplungszweig zur Verringerung der Verstärkung und damit zur Begrenzung der Stellgröße geschlossen wird.

Das Schließen des Rückkopplungszweigs kann vorteilhafterweise mit Hilfe von steuerbaren Schaltern erfolgen, wobei insbesondere der Einsatz von Halbleiterschaltern (beispielsweise Dioden oder Transistoren) vorteilhaft ist, die eine kontinuierliche Kennlinie aufweisen, so daß ein fließender Übergang zwischen den zuvor beschriebenen Regelungszuständen realisiert werden kann.

Die vorliegende Erfindung eignet sich allgemein zur Regelung der Ausgangsleistung beliebig ausgestalteter Leistungsverstärker. Sie ist jedoch insbesondere für Hochfrequenz-Leistungsverstärker vorteilhaft, wie sie beispielsweise in Mobilfunkgeräten (z.B. Mobiltelefonen), zum Einsatz kommen.

Die Erfindung wird nachfolgend näher unter Bezugnahme auf die beigefügte Zeichnung anhand bevorzugter Ausführungsbeispiele erläutert.

Fig. 1 zeigt eine Schaltungsanordnung zur Erläuterung des der Erfindung zugrundeliegenden Prinzips gemäß einem ersten Ausführungsbeispiel, und

Fig. 2 zeigt eine Schaltungsanordnung gemäß einem zweiten Ausführungsbeispiel der vorliegenden Erfindung.

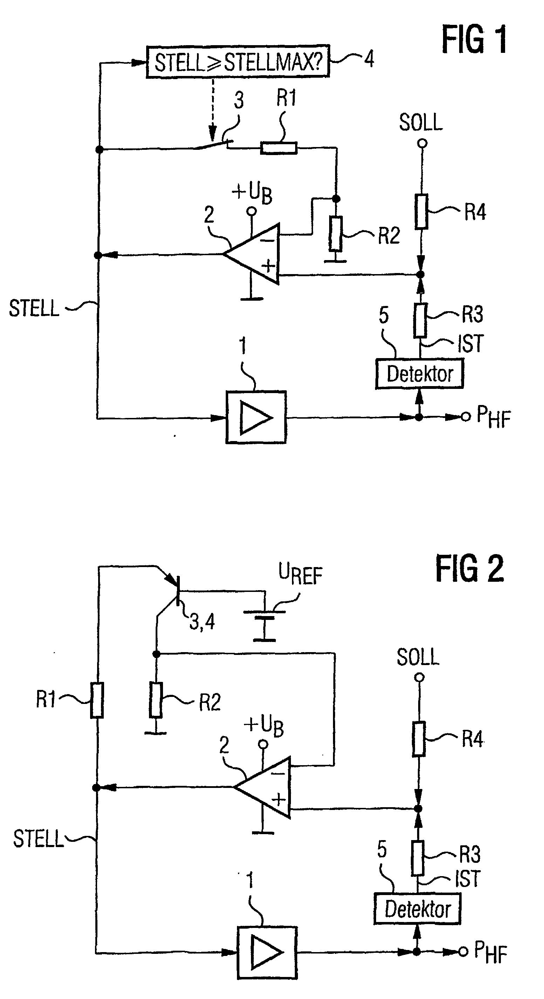

In Fig. 1 ist ein Hochfrequenz-Leistungsverstärker 1 dargestellt, dessen Ausgangsleistung P_{HF} mit Hilfe eines Regelkreises geregelt wird, um die Ausgangsleistung gegenüber Störeinflüssen zu stabilisieren. Von einem Detektor 5 wird der augenblickliche Wert oder Istwert IST einer der Ausgangsleistung P_{HF} des Hochfrequenz-Leistungsverstärkers 1 entsprechenden Meßgröße erfaßt, der über einen Widerstand R3 in die Regelung einfließt. Diese Meßgröße kann beispielsweise einer durch Gleichrichtung der Hochfrequenz gewonnenen analogen Spannung entsprechen. Über einen weiteren Widerstand R4 wird ein mit dem Istwert IST zu vergleichender Sollwert SOLL angelegt oder zugeführt, der einer entsprechenden Soll-Ausgangsleistung des Hochfrequenz-Leistungsverstärkers 1 entspricht. Der Sollwert SOLL und der Istwert IST werden über den dargestellten Spannungsteiler betragsmäßig verglichen, wobei die daraus resultierende Differenz einem Regler 2 zugeführt wird.

Der Regler 2 ist im dargestellten Ausführungsbeispiel in Form eines mit einer Versorgungsspannung U_{B} betriebenen differenzbildenden Verstärkers ausgestaltet und erzeugt abhängig von der betragsmäßigen Differenz zwischen dem Sollwert SOLL und dem Istwert IST eine Stellgröße STELL, die an einen Steuereingang des Hochfrequenz-Leistungsverstärkers 1 geführt ist, um dessen Ausgangsleistung P_{HF} entsprechend einzustellen.

Der Ausgang des Reglers oder Verstärkers 2 ist über einen Rückkopplungszweig, der einen steuerbaren Schalter 3 sowie Widerstände R1 und R2 enthält, mit seinem invertierenden Eingang verbunden.

Die von dem Regler 2 erzeugte Stellgröße wird von einer Steuerung 4 ausgewertet und mit einem vorgegeben Grenzwert STELLMAX verglichen. Dieser Grenzwert STELLMAX entspricht demjenigen Wert der Stellgröße, der zu einem Ausgangsleistungswert des Hochfrequenz-Leistungsverstärkers 1 in der Nähe der Maximalleistung führen würde.

Ist bei niedrigen bis mittleren Ausgangsleistungen der augenblickliche Wert der Stellgröße STELL < STELLMAX, bleibt der Schalter 3 geöffnet. Der Regler 2 arbeitet in diesem Fall ohne Rückkopplung, und es erfolgt eine Regelung der Ausgangsleistung P_{HF} mit einer hohen Regelkreisverstärkung.

Bei Stellgrößen, wie sie nahe der maximalen Ausgangsleistung P_{HF} des Hochfrequenz-Leistungsverstärkers 1 auftreten, d.h. bei STELL ≥ STELLMAX, wird hingegen der Rückkopplungszweig geschlossen und der Regler 2 somit stark gegengekoppelt, wobei die Verstärkung auf eine durch die Widerstandswerte von R1 und R2 festgelegte, niedrigere Verstärkung umgeschaltet wird. Die von dem Regler 2 erzeugte Stellgröße STELL folgt dann dem Sollwert SOLL nur noch mit geringerem Durchgriff. Ein "Rollover" kann somit zuverlässig vermieden werden, da die Stellgröße STELL frühzeitig begrenzt wird, der Regler 2 sich jedoch immer im gegengekoppelten, linearen Betrieb befindet.

Es kann vorteilhaft sein, Schalter 3 zu verwenden, die eine kontinuierliche Kennlinie aufweisen, wie beispielsweise Dioden, Bipolar- oder MOS-FET-Transistoren, so daß zwischen den beiden zuvor beschriebenen Regelungszuständen ein fließender Übergang realisiert wird.

Ein entsprechendes Ausführungsbeispiel ist in Fig. 2 für einen Hochfrequenz-Leistungsverstärker 1 mit positivem Stellspannungsbereich dargestellt. Die den bereits in Fig. 1 gezeigten Komponenten entsprechenden Komponenten sind mit denselben Bezugszeichen versehen, so daß ergänzend auf die obige Beschreibung zu Fig. 1 verwiesen wird.

Bei dem vorliegenden Ausführungsbeispiel wird ein pnp-Bipolartransistor verwendet, an dessen Basis eine mit dem augenblicklichen Wert der Stellgröße zu vergleichende Referenzspannung U_{REF} angelegt ist. Überschreitet die Stellgröße STELL den Wert der vorgegebenen Referenzspannung U_{REF}, wird der zunächst nicht gegengekoppelte Verstärker oder Regler 2 auf eine durch die Wiederstände R1 und R2 festgelegte, niedrigere Verstärkung umgeschaltet. Der dargestellte Bipolartransistor übernimmt somit sowohl die Funktion des in Fig. 1 gezeigten Schalters 3 als auch die Funktion der in Fig. 1 gezeigten Steuerung 4.

## Patentansprüche

1. Verfahren zur Regelung der Ausgangsleistung eines Leistungsverstärkers, umfassend die Schritte
a) Erfassen des augenblicklichen Werts (IST) einer der augenblicklichen Ausgangsleistung (P_{HF}) des Leistungsverstärkers (1) entsprechenden Meßgröße,
b) Vergleichen des Werts (IST) der im Schritt a) erfaßten Meßgröße mit einem vorgegebenen Sollwert (SOLL), und
c) Erzeugen einer dem Leistungsverstärker (1) zuzuführenden Stellgröße (STELL) mit Hilfe eines Regler (2) in Abhängigkeit von dem Ergebnis des im Schritt b) durchgeführten Vergleichs, um die Ausgangsleistung (P_{HF}) des Leistungsverstärkers (1) entsprechend der Stellgröße (STELL) einzustellen,
**dadurch gekennzeichnet,**
**daß** der Regler (2) einen Verstärker aufweist, und
**daß** der Wert der im Schritt c) erzeugten Stellgröße (STELL) mit einem vorgegebenen Grenzwert (STELLMAX) verglichen und davon abhängig die Verstärkung (R1,R2,3) des Reglers (2) eingestellt wird.

2. Verfahren nach Anspruch 1,
**dadurch gekennzeichnet,**
**daß** der mit dem Wert der Stellgröße (STELL) zu vergleichende Grenzwert (STELLMAX) einem Stellgrößenwert entspricht, welcher nahezu einer maximalen Ausgangsleistung des Leistungsverstärkers (1) entspricht.

3. Verfahren nach Anspruch 1 oder 2,
**dadurch gekennzeichnet,**
**daß** die Verstärkung des Reglers (2) auf einen ersten Verstärkungsfaktor eingestellt wird, falls der Wert der Stellgröße (STELL) kleiner als der vorgegebene Grenzwert (STELLMAX) ist, und
**daß** die Verstärkung des Reglers (2) auf einen zweiten Verstärkungsfaktor eingestellt wird, welcher kleiner als der erste Verstärkungsfaktor ist, falls der Wert der Stellgröße (STELL) größer als der vorgegebene Grenzwert (STELLMAX) ist.

4. Verfahren nach Anspruch 3,
**dadurch gekennzeichnet,**
**daß** die Einstellung des niedrigeren zweiten Verstärkungsfaktors des Reglers (2) durch Rückkoppeln des Reglers (2) erfolgt.

5. Verfahren nach Anspruch 4,
**dadurch gekennzeichnet,**
**daß** das Umschalten der Verstärkung des Reglers (2) zwischen dem ersten Verstärkungsfaktor und dem zweiten Verstärkungsfaktor mit Hilfe eines in den Rückkopplungszweig des Reglers (2) geschalteten Schalter (3) erfolgt.

6. Schaltungsanordnung zur Regelung der Ausgangsleistung eines Leistungsverstärkers,
mit einer Istwert-Erfassungseinrichtung (5) zum Erfassen des augenblicklichen Werts (IST) einer der augenblicklichen Ausgangsleistung (P_{HF}) des Leistungsverstärkers (1) entsprechenden Meßgröße, und
mit einer Regeleinrichtung (2) zum Erzeugen einer dem Leistungsverstärker (1) zuzuführenden Stellgröße (STELL) in Abhängigkeit von dem Verhältnis zwischen dem augenblicklichen Wert (IST) der von der Istwert-Erfassungseinrichtung (5) erfaßten Meßgröße und einem vorgebbaren Sollwert (SOLL),
wobei die Stellgröße (STELL) dem Leistungsverstärker (1) zugeführt ist, um die Ausgangsleistung (P_{HF}) des Leistungsverstärkers (1) entsprechend der Stellgröße (STELL) einzustellen,
**dadurch gekennzeichnet,**
**daß** die Regeleinrichtung (2) einen Verstärker aufweist, und daß eine Steuereinrichtung (3, 4) zum Vergleichen des Werts der von der Regeleinrichtung (2) erzeugten Stellgröße (STELL) mit einem vorgegebenen Grenzwert (STELLMAX) und zum Einstellen der Verstärkung (R1,R2,3) der Regeleinrichtung (2) in Abhängigkeit von dem Ergebnis dieses Vergleiches vorgesehen ist.

7. Schaltungsanordnung nach Anspruch 6,
**dadurch gekennzeichnet,**
**daß** der mit dem Wert der Stellgröße (STELL) zu vergleichende Grenzwert (STELLMAX) einem Stellgrößenwert entspricht, welcher nahezu einer maximalen Ausgangsleistung des Leistungsverstärkers (1) entspricht.

8. Schaltungsanordnung nach Anspruch 6 oder 7,
**dadurch gekennzeichnet,**
**daß** die Steuereinrichtung (3, 4) derart ausgestaltet ist, daß sie die Verstärkung der Regeleinrichtung (2) auf einen ersten Verstärkungsfaktor einstellt, falls der Wert der Stellgröße (STELL) kleiner als der vorgegebene Grenzwert (STELLMAX) ist, während die Steuereinrichtung (3, 4) die Verstärkung der Regeleinrichtung (2) auf einen zweiten Verstärkungsfaktor eingestellt, welcher kleiner als der erste Verstärkungsfaktor ist, falls der Wert der Stellgröße (STELL) größer als der vorgegebene Grenzwert (STELLMAX) ist.

9. Schaltungsanordnung nach Anspruch 8,
**dadurch gekennzeichnet,**
**daß** die Regeleinrichtung (2) einen über einen Schalter (3) rückgekoppelten Regler (2) umfaßt, und
**daß** die Steuereinrichtung (4) derart ausgestaltet ist, daß sie zwischen dem ersten Verstärkungsfaktor und dem zweiten Verstärkungsfaktor durch Öffnen bzw. Schließen des Schalters (3) umschaltet.

10. Schaltungsanordnung nach Anspruch 9,
**dadurch gekennzeichnet,**
**daß** der Regler (2) durch einen Verstärker gebildet ist, dessen Ausgang über den Schalter (3) mit seinem invertierenden Eingang verbunden ist, und
**daß** die Steuereinrichtung (4) zur Einstellung des niedrigeren zweiten Verstärkungsfaktors den Schalter (3) schließt.

11. Schaltungsanordnung nach Anspruch 9 oder 10,
**dadurch gekennzeichnet,**
**daß** die Steuereinrichtung (4) und der Schalter (3) durch ein Bauteil realisiert ist, an welches eine mit dem Wert der von dem Regler (2) erzeugten Stellgröße zu vergleichende Referenzgröße (U_{REF}) angelegt ist.

12. Schaltungsanordnung nach Anspruch 11,
**dadurch gekennzeichnet,**
**daß** die Steuereinrichtung (4) und der Schalter (3) durch ein Halbleiter-Bauteil mit einer kontinuierlichen Kennlinie realisiert ist, an welches eine mit dem Wert der von dem Regler (2) erzeugten Stellgröße zu vergleichende Referenzgröße (U_{REF}) angelegt ist.

13. Schaltungsanordnung nach einem der Ansprüche 6-12,
**dadurch gekennzeichnet,**
**daß** der Leistungsverstärker (1) ein Hochfrequenz-Leistungsverstärker ist.

## Claims

1. Method for controlling the output power of a power amplifier,
comprising the following steps:
a) detection of the instantaneous value (ACT) of a measurement variable which corresponds to the instantaneous output power (P_{RF}) of the power amplifier (1),
b) comparison of the value (ACT) of the measurement variable detected in step a) with a predetermined nominal value (NOM), and
c) production of a manipulated variable (MAN), which is to be supplied to the power amplifier (1), with the aid of a regulator (2), as a function of the result of the comparison carried out in step b), in order to set the output power (P_{RF}) of the power amplifier (1) in accordance with the manipulated variable (MAN),
**characterized**
**in that** the regulator (2) has an amplifier, and
**in that** the value of the manipulated variable (MAN) produced in step c) is compared with a predetermined limit value (MANMAX), and the gain (R1, R2, 3) of the regulator (2) is set as a function of this.

2. Method according to Claim 1,
**characterized**
**in that** the limit value (MANMAX) which is to be compared with the value of the manipulated variable (MAN) corresponds to a manipulated variable value which corresponds approximately to a maximum output power of the power amplifier (1).

3. Method according to Claim 1 or 2,
**characterized**
**in that** the gain of the regulator (2) is set to a first gain factor if the value of the manipulated variable (MAN) is less than the predetermined limit value (MANMAX), and
**in that** the gain of the regulator (2) is set to a second gain factor, which is less than the first gain factor, if the value of the manipulated variable (MAN) is greater than the predetermined limit value (MANMAX).

4. Method according to Claim 3,
**characterized**
**in that** the lower second gain factor of the regulator (2) is set by feedback from the regulator (2).

5. Method according to Claim 4,
**characterized**
**in that** the gain of the regulator (2) is switched between the first gain factor and the second gain factor with the aid of a switch (3) which is connected in the feedback path of the regulator (2).

6. Circuit arrangement for controlling the output power of a power amplifier,
having an actual value detection device (5) for detecting the instantaneous value (ACT) of a measurement variable which corresponds to the instantaneous output power (P_{RF}) of the power amplifier (1), and
having a regulating device (2) for producing a manipulated variable (MAN), which is to be supplied to the power amplifier (1) as a function of the ratio between the instantaneous value (ACT) of the measurement variable detected by the actual value detection device (5) and a nominal value (NOM) which can be predetermined
with the manipulated variable (MAN) being supplied to the power amplifier (1) in order to set the output power (P_{RF}) of the power amplifier (1) in accordance with the manipulated variable (MAN),
**characterized**
**in that** the regulating device (2) has an amplifier, and
**in that** a control device (3, 4) is provided for comparing the value of the manipulated variable (MAN) produced by the regulating device (2) with a predetermined limit value (MANMAX), and for setting the gain (R1, R2, 3) of the regulating device (2) as a function of the result of this comparison.

7. Circuit arrangement according to Claim 6,
**characterized**
**in that** the limit value (MANMAX) which is to be compared with the value of the manipulated variable (MAN) corresponds to a manipulated variable value which corresponds approximately to a maximum output power of the power amplifier (1).

8. Circuit arrangement according to Claim 6 or 7,
**characterized**
**in that** the control device (3, 4) is designed such that it sets the gain of the regulating device (2) to a first gain factor if the value of the manipulated variable (MAN) is less than the predetermined limit value (MANMAX), while the control device (3, 4) sets the gain of the regulating device (2) to a second gain factor, which is less than the first gain factor, if the value of the manipulated variable (MAN) is greater than the predetermined limit value (MANMAX).

9. Circuit arrangement according to Claim 8,
**characterized**
**in that** the regulating device (2) has a regulator (2) with feedback via a switch (3), and
**in that** the control device (4) is designed such that it switches between the first gain factor and the second gain factor by opening and closing of the switch (3).

10. Circuit arrangement according to Claim 9,
**characterized**
**in that** the regulator (2) is formed by an amplifier whose output is connected via the switch (3) to its inverting input, and
**in that** the control device (4) closes the switch (3) in order to set the lower, second gain factor.

11. Circuit arrangement according to Claim 9 or 10,
**characterized**
**in that** the control device (4) and the switch (3) are formed by one component, to which a reference variable (U_{REF}), which is to be compared with the value of the manipulated variable produced by the regulator (2), is applied.

12. Circuit arrangement according to Claim 11,
**characterized**
**in that** the control device (4) and the switch (3) are formed by a semiconductor component with a continuous characteristic, to which a reference variable (U_{REF}), which is to be compared with the value of the manipulated variable produced by the regulator (2), is applied.

13. Circuit arrangement according to one of Claims 6-12,
**characterized**
**in that** the power amplifier (1) is a radio-frequency power amplifier.

## Revendications

1. Procédé pour réguler la puissance de sortie d'un amplificateur de puissance,
comprenant les étapes suivantes
a) saisie de la valeur momentanée (IST) d'une grandeur mesurée correspondant à la puissance de sortie (P_{HF}) momentanée de l'amplificateur de puissance (1),
b) comparaison de la valeur (IST) de la grandeur mesurée saisie à l'étape a) à une valeur de consigne prédéfinie (SOLL), et
c) génération d'une grandeur réglante (STELL) à amener à l'amplificateur de puissance (1) à l'aide d'un régulateur (2), en fonction du résultat de la comparaison réalisée à l'étape b), afin de régler la puissance de sortie (P_{HF}) de l'amplificateur de sortie (1) de manière correspondant à la grandeur réglante (STELL),
**caractérisé en ce que**
le régulateur (2) comprend un amplificateur et **en ce que** la valeur de la grandeur réglante (STELL) générée à l'étape c) est comparée à une valeur limite prédéfinie (STELLMAX) et **en ce que**, en fonction de cela, l'amplification (R1, R2, 3) du régulateur (2) est réglée.

2. Procédé suivant la revendication 1,
**caractérisé en ce que**
la valeur limite (STELLMAX) à comparer à la valeur de la grandeur réglante (STELL) correspond à une valeur de grandeur réglante, laquelle correspond presque à une puissance de sortie maximale de l'amplificateur de puissance (1).

3. Procédé suivant la revendication 1 ou 2,
**caractérisé en ce que**
l'amplification du régulateur (2) est réglée sur un premier facteur d'amplification au cas où la valeur de la grandeur réglante (STELL) est inférieure à la valeur limite prédéfinie (STELLMAX), et
**en ce que** l'amplification du régulateur (2) est réglée sur un deuxième facteur d'amplification, lequel est inférieur au premier facteur d'amplification au cas où la valeur de la grandeur réglante (STELL) est supérieure à la valeur limite prédéfinie (STELLMAX).

4. Procédé suivant la revendication 3,
**caractérisé en ce que**
le réglage du deuxième facteur plus bas d'amplification du régulateur (2) est réalisé par rétroaction du régulateur (2).

5. Procédé suivant la revendication 4,
**caractérisé en ce que**
la commutation de l'amplification du régulateur (2) entre le premier facteur d'amplification et le deuxième facteur d'amplification est réalisée à l'aide d'un commutateur (3) couplé dans la branche de retour du régulateur (2).

6. Circuit pour réguler la puissance de sortie d'un amplificateur de puissance,
avec un dispositif de saisie de la valeur réelle (5) pour saisir la valeur momentanée (IST) d'une grandeur mesurée correspondant à la puissance de sortie (P_{HF}) momentanée de l'amplificateur de puissance (1), et
avec un dispositif de régulation (2) pour générer une grandeur réglante (STELL) à amener à l'amplificateur de puissance (1) en fonction du rapport entre la valeur momentanée (IST) de la grandeur mesurée saisie par le dispositif de saisie de la valeur réelle (5) et une valeur de consigne pouvant être prédéfinie (SOLL),
la grandeur réglante (STELL) étant amenée à l'amplificateur de puissance (1) afin de régler la puissance de sortie (P_{HF}) de l'amplificateur de puissance (1) de manière correspondant à la grandeur réglante (STELL),
**caractérisé en ce que**
le dispositif de régulation (2) présente un amplificateur, et **en ce qu'**un dispositif de commande (3, 4) est prévu pour comparer la valeur de la grandeur réglante (STELL) générée par le dispositif de régulation (2) à une valeur limite prédéfinie (STELLMAX) et pour régler l'amplification (R1, R2, 3) du dispositif de régulation (2) en fonction du résultat de cette comparaison.

7. Circuit suivant la revendication 6,
**caractérisé en ce que** la valeur limite (STELLMAX) à comparer à la valeur de la grandeur réglante (STELL) correspond à une valeur de grandeur réglante, laquelle correspond presque à une puissance de sortie maximale de l'amplificateur de puissance (1).

8. Circuit suivant la revendication 6 ou 7,
**caractérisé en ce que**
le dispositif de commande (3, 4) est exécuté de telle manière qu'il règle l'amplification du dispositif de régulation (2) sur un premier facteur d'amplification au cas où la valeur de la grandeur réglante (STELL) est inférieure à la valeur limite prédéfinie (STELLMAX), alors que le dispositif de commande (3, 4) règle l'amplification du dispositif de régulation (2) sur un deuxième facteur d'amplification, lequel est inférieur au premier facteur d'amplification au cas où la valeur de la grandeur réglante (STELL) est supérieure à la valeur limite prédéfinie (STELLMAX).

9. Circuit suivant la revendication 8,
**caractérisé en ce que**
le dispositif de régulation (2) comprend un régulateur (2) à rétroaction par l'intermédiaire d'un commutateur (3), et
**en ce que** le dispositif de commande (4) est exécuté de telle manière qu'il commute entre le premier facteur d'amplification et le deuxième facteur d'amplification en ouvrant resp. fermant le commutateur (3).

10. Circuit suivant la revendication 9,
**caractérisé en ce que**
le régulateur (2) est formé par un amplificateur dont la sortie est connectée à son entrée invertissante par l'intermédiaire du commutateur (3), et
**en ce que** le dispositif de commande (4) ferme le commutateur (3) pour la régulation du deuxième facteur d'amplification plus bas.

11. Circuit suivant la revendication 9 ou 10,
**caractérisé en ce que**
le dispositif de commande (4) et le commutateur (3) sont réalisés par une pièce sur laquelle une grandeur de référence (U_{REF}) à comparer à la valeur de la grandeur réglante générée par le régulateur (2) est mise.

12. Circuit suivant la revendication 11,
**caractérisé en ce que**
le dispositif de commande (4) et le commutateur (3) sont réalisés par une pièce de semi-conducteur ayant une caractéristique continue, sur laquelle une grandeur de référence (U_{REF}) à comparer à la valeur de la grandeur réglante générée par le régulateur (2) est mise.

13. Circuit suivant l'une des revendications 6-12,
**caractérisé en ce que**
l'amplificateur de puissance (1) est un amplificateur de puissance à haute fréquence.
